Europäisches Patentamt

European Patent Office

Office européen des brevets

(19)

(11) Veröffentlichungsnummer: **0 136 575**
**B1**

(12) # EUROPÄISCHE PATENTSCHRIFT

(45) Veröffentlichungstag der Patentschrift:
01.07.87

(21) Anmeldenummer: 84110464.9

(22) Anmeldetag: 03.09.84

(51) Int. Cl.⁴: **B 23 K 1/12 //**
**H01R43/02**

(54) **Löteinrichtung, insbesondere zum Herstellen von nachträglichen Verbindungsänderungen an Leiterplatten.**

(30) Priorität: 21.09.83 DE 3334182

(43) Veröffentlichungstag der Anmeldung:
10.04.85 Patentblatt 85/15

(45) Bekanntmachung des Hinweises auf die Patenterteilung:
01.07.87 Patentblatt 87/27

(84) Benannte Vertragsstaaten:
AT BE CH DE FR GB IT LI NL SE

(56) Entgegenhaltungen:
WO-A-81/01115
DE-A-3 025 875

(73) Patentinhaber: Siemens Aktiengesellschaft Berlin
und München, Wittelsbacherplatz 2, D-8000
München 2 (DE)

(72) Erfinder: Thorwarth, Rüdiger, Tillystrasse 4, D-8019
Glonn (DE)

## Beschreibung

Die Erfindung betrifft eine Löteinrichtung nach dem Oberbegriff des Anspruchs 1.

Bei mit Bauteilen bestückten Leiterplatten müssen auf der Schwallseite häufig nachträgliche Verbindungsänderungen zwischen Bauteileanschlüssen und Leiterbahnanschlüssen hergestellt werden. Hierzu werden Änderungsdrähte an ihren Enden abisoliert, verzinnt und zu Ösen eingerollt. Die Ösen dienen dabei zur mechanischen Fixierung der Änderungsdrähte an den das der Leiterplatte überstehenden Bauteileanschlüssen. Als Löteinrichtungen für das Anlöten der Änderungsdrähte werden dauerbeheizte elektrische Lötkolben mit hohlgebohrter Spitze verwendet, deren Arbeitsfläche auf die Lötstelle aufgesetzt wird. Während des Lötvorganges werden die Ösen der Änderungsdrähte manuell positioniert. Da der Lötkolben aus dem schmelzflüssigen Lot abgehoben werden muß, ist es notwendig, den Änderungsdraht bis zum Erstarren des Lotes festzuhalten, wodurch dann aber andererseits sogenannte kalte Lötstellen auftreten können. Durch Verkürzung der Bauteileanschlüsse, so daß diese nicht mehr aus der Leiterplatte herausragen, und durch die Forderung Änderungsdrähte auch an nicht bestückte Durchkontaktierungen anzulöten, können die Fixierhilfen für das Anlöten der Änderungsdrähte entfallen. Außerdem reicht das durch den Schwallvorgang an den Anschlußflächen der Leiterplatte abgeschiedene Lot beim Anlöten mehrerer Änderungsdrähte nicht für ein Einbetten der Ösen dieser Änderungsdrähte aus.

Der Erfindung liegt die Aufgabe zugrunde, eine zum Herstellen von nachträglichen Verbindungsänderungen an Leiterplatten geeignete Löteinrichtung zu schaffen, mit welcher ggf. auch mehrere Änderungsdrähte ohne Fixierhilfe durch überstehende Bauteileanschlüsse an eine Anschlußfläche angelötet werden können, wobei das Auftreten kalter Lötstellen mit Sicherheit ausgeschlossen werden soll.

Diese Aufgabe wird bei einer gattungsgemäßen Löteinrichtung durch die kennzeichnenden Merkmale des Anspruchs 1 gelöst.

Die mit der Erfindung erzielten Vorteile bestehen insbesondere darin, daß durch in den Hohlraum der Lötbacken eingebrachtes Lot im geschlossenen Zustand der Lötbacken Lotkuppen geformt werden können, welche die Öse eines Änderungsdrahtes einbetten. Diese Lotkuppen dienen dann beim Kontaktieren weiterer Änderungsdrähte sowohl als Zentrierhilfe als auch als Lotdepot. Ein Auftreten kalter Lötstellen wird dadurch ausgeschlossen, daß die geschlossenen Lötbacken beim Lötvorgang als Niederhalter für die Anschlußdrähte dienen und diese Funktion bis zum Erstarren des Lotes wahrnehmen. Die Lötbacken werden dann erst im erkalteten Zustand geöffnet und von der Lötstelle abgehoben. Die erfindungsgemäße Löteinrichtung läßt sich aber auch zum Kontaktieren von Änderungsdrähten an aus der Leiterplatte überstehenden Bauteileanschlüssen einsetzen. Dabei wird jedoch kein Zusatzlot in die Lötbacken eingeführt. Die Lötbacken umschließen den Bauteileanschluß und dienen auch hier während des Lötvorganges und des Abkühlvorganges als Niederhalter.

Gemäß einer weiteren Ausgestaltung der Erfindung sind die Lötbacken federnd auf die Lötstelle drückbar. Hierdurch wird die Wirkung der Lötbacken als Niederhalter weiter verbessert.

Bei einer weiteren bevorzugten Ausgestaltung der Erfindung ist in jede Lötbacke ein vor der Arbeitsfläche endender Schlitz eingebracht, wobei die durch den Schlitz voneinander getrennten Lötbackenteile an eine Stromquelle angeschlossen sind. Auf diese Weise können die Arbeitsfläche und die daran angrenzenden Bereiche der Lötbacken gleichmäßig auf die erforderliche Arbeitstemperatur erwärmt werden.

Vorzugsweise ist jeder Lötbacke ein regelbarer Transformator zugeordnet, wodurch eine kontrollierte Erwärmung auf die erforderliche Arbeitstemperatur ermöglicht wird. Mit Hilfe eines an eine Lötbacke angebrachten Thermoelements kann auch eine über die Dauer der Lötzeit konstante Arbeitstemperatur eingestellt werden. In diesem Fall werden beide Lötbacken an ein gemeinsames Steuergerät angeschlossen. Außerdem ist es besonders günstig, wenn jede Lötbacke durch einen Stromimpuls heizbar ist. Die Zeitdauer eines Stromimpulses und die Leistung können dann auf besonders einfache Weise durch einen Takter gesteuert werden.

Die Erfindung gibt auch ein Verfahren zum Anlöten von Änderungsdrähten an Anschlußflächen einer Leiterplatte unter Verwendung einer erfindungsgemäßen Löteinrichtung an. Dabei ist vorgesehen, daß zunächst eine definierte Menge Lotdraht zwischen die geöffneten Lötbacken eingebracht wird, daß dann die Lötbacken geschlossen und mit einem Stromimpuls derart beheizt werden, daß das in den Hohlraum der Lötbacken eingeklemmte Lot abgeschmolzen wird und sich ein aus der Arbeitsfläche herausragender Lottropfen bildet, daß nach dem Erstarren des Lottropfens die Lötbacken auf die mit einer Öse des Änderungsdrahtes belegte Anschlußfläche gedrückt werden, daß die Lötbacken erneut mit einem Stromimpuls zum Aufschmelzen des Lottropfens beheizt werden und daß die Lötbacken bis zum Erstarren des Lotes auf der Anschlußfläche verbleiben. Dabei wird das Auftreten kalter Lötstellen durch den Einsatz der Lötbacken als Niederhalter mit Sicherheit ausgeschlossen. Die Bildung des Lottropfens hat den Vorteil, daß dieser nach seinem Erstarren beim Absenken der Lötbacken auf die mit der Öse des Anschlußdrahtes belegte Anschlußfläche als Zentrierhilfe verwendet werden kann. Beim erneuten Aufschmelzen des Lottropfens wird dann durch die Lötbacken eine Lotkuppe geformt, welche die Öse des Änderungsdrahtes einbettet. Im Anschluß an den Lötvorgang werden die Lötbacken dann zweckmäßigerweise nach dem Erstarren des Lotes geöffnet und von der Anschlußfläche abgehoben.

Die beim Anlöten eines Änderungsdrahtes auf der Anschlußfläche gebildete Lotkuppe kann dann beim Anlöten eines weiteren Änderungsdrahtes vorteilhaft als Zentrierhilfe und als Lotdepot verwendet werden. Vorzugsweise wird dabei zum Anlöten eines weiteren Änderungsdrahtes zunächst dessen Öse um die Lotkuppe gelegt, worauf dann die geschlossenen Lötbacken abgesenkt und mit einem Stromimpuls zum Aufschmelzen der Lotkuppe beheizt werden, wobei die Lötbacken bis zum Erstarren des Lotes auf der Anschlußfläche verbleiben.

Ein Ausführungsbeispiel der Erfindung und die Herstellung von nachträglichen Verbindungsänderungen an Leiterplatten sind in der Zeichnung dargestellt und werden im folgenden näher bechrieben.

Es zeigen:

Figur 1 eine Löteinrichtung mit geöffneten halbschalenförmigen Lötbacken und deren Anordnung in bezug auf eine Anschlußfläche einer Leiterplatte,

Figur 2 die Löteinrichtung nach Figur 1 mit geschlossenen und auf die Anschlußfläche abgesenkten Lötbacken,

Figur 3 eine auf der Anschlußfläche gebildete Lotkuppe, in welche die Öse eines Änderungsdrahtes eingebettet ist,

Figur 4 das Anlöten eines weiteren Änderungsdrahtes und

Figur 5 das Anlöten von zwei weiteren Änderungsdrähten.

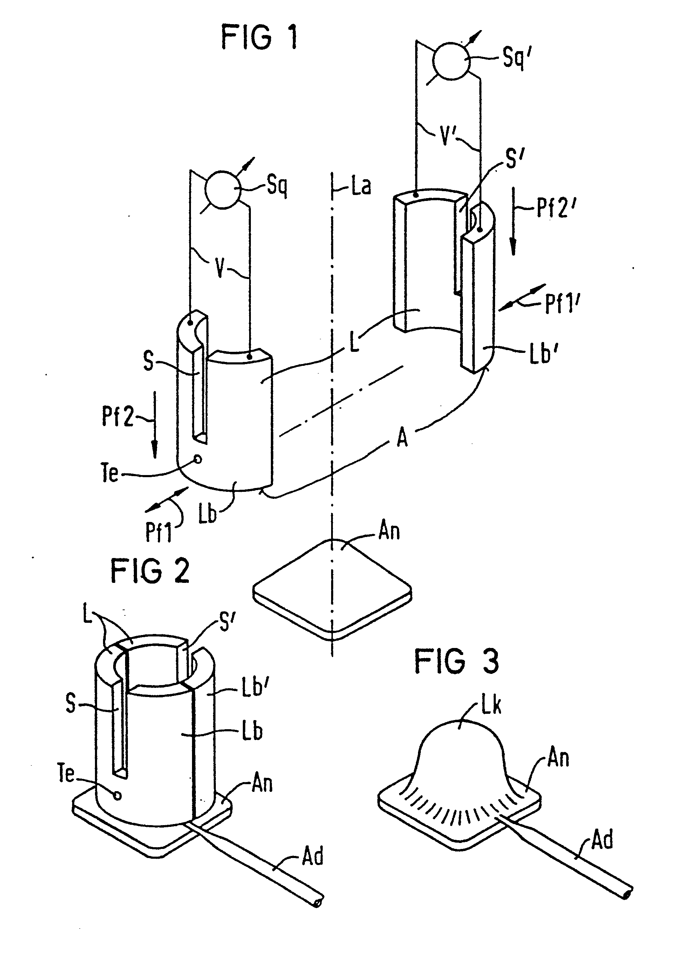

Figur 1 zeigt in stark vereinfachter schematischer Darstellung eine Löteinrichtung, deren Lötelement L aus zwei halbschalenförmigen Lötbacken Lb und Lb' besteht. Die untere Kreisringfläche der Lötbacken Lb und Lb' bildet dabei die Arbeitsfläche A des Lötelements L. Zum Öffnen und Schließen des Lötelements L sind die beiden Lötbacken Lb und Lb' in horizontaler Richtung relativ zueinander verstellbar, was in Figur 1 durch entsprechende Doppelpfeile Pf1 bzw. Pf1' angedeutet ist. Darüberhinaus können die Lötbacken Lb und Lb' in vertikaler Richtung abgesenkt und federnd gegen die Anschlußfläche an einer nicht näher dargestellten Leiterplatte gedrückt werden, was in Figur 1 durch entsprechende Pfeile Pf2 und Pf2' angedeutet ist.

In die beiden aus einem Widerstandsmaterial, wie z. B. Titan oder einem hochwarmfesten CrNi-Stahl, bestehenden Lötbacken Lb und Lb' sind achsparallele und jeweils vor der Arbeitsfläche A endende Schlitze S bzw. S' eingebracht. Die durch die Schlitze S bzw. S' voneinander getrennten Lötbackenteile sind dann jeweils über elektrische Verbindungsleitungen V bzw. V' an regelbare Stromquellen Sq bzw. Sq' angeschlossen. Diese in Figur 1 nur schematisch dargestellten Stromquellen Sq bzw. Sq' bestehen aus getrennt regelbaren Transformatoren, wobei die Beheizung der Lötbacken Lb bzw. Lb' durch Stromimpulse erfolgt. Dabei sind die Zeitdauer eines Stromimpulses und die Leistung durch Takter steuerbar. Zur Erzielung einer über die Dauer der Lötzeit konstanten und regelbaren Arbeitstemperatur kann an eine Lötbacke Lb auch ein in der Zeichnung schematisch angedeutetes Thermoelement Te angebracht werden. In diesem Fall werden dann beide Lötbacken Lb und Lb' an ein gemeinsames Steuergerät angeschlossen.

Soll nun an die Anschlußfläche An ein Änderungsdraht angelötet werden, so wird zunächst eine definierte Menge Lotdraht zwischen die geöffneten Lötbacken Lb und Lb' eingebracht. Daraufhin werden die Lötbacken Lb und Lb' geschlossen, so daß das Lötelement L die Gestalt eines Hohlzylinders annimmt, dessen vertikale Längsachse La durch die Mitte der Anschlußfläche An verläuft. Nach dem Schließvorgang werden die Lötbacken Lb und Lb' durch entsprechende Stromimpulse derart beheizt, daß das in den Hohlraum des Lötelements L eingeklemmte Lot abgeschmolzen wird und sich durch die Oberflächenspannung des schmelzflüssigen Lotes ein aus der Arbeitsfläche A herausragender Lottropfen bildet. Nach dem Erstarren dieses Lottropfens werden die Lötbacken Lb und Lb' in Richtung der Pfeile Pf2 bzw. Pf2' abgesenkt und federnd gegen die mit der verzinnten Öse eines in Figur 1 nicht näher dargestellten Änderungsdrahtes belegte Anschlußfläche An gedrückt. Der erstarrte Lottropfen dient hierbei als Zentrierhilfe. Danach werden die Lötbacken Lb und Lb' erneut mit einem Stromimpuls derart beheizt, daß der Lottropfen aufgeschmolzen wird. Die entsprechende Stellung des geschlossenen Lötelements L, welches gegen die Anschlußfläche An gedrückt wird und dabei als Niederhalter für einen Änderungsdraht Ad dient, geht aus Figur 2 hervor. In dieser Stellung wird dann das Lötelement L bis zum Erstarren des Lotes belassen. Danach werden die Lötbacken Lb und Lb' des Lötelements L geöffnet und von der Anschlußfläche An abgehoben. Aus Figur 3 ist ersichtlich, daß beim Aufschmelzen des Lottropfens in den Lötbacken Lb und Lb' eine Lotkuppe Lk geformt wurde, in welche die Öse des Änderungsdrahtes Ad eingebettet ist.

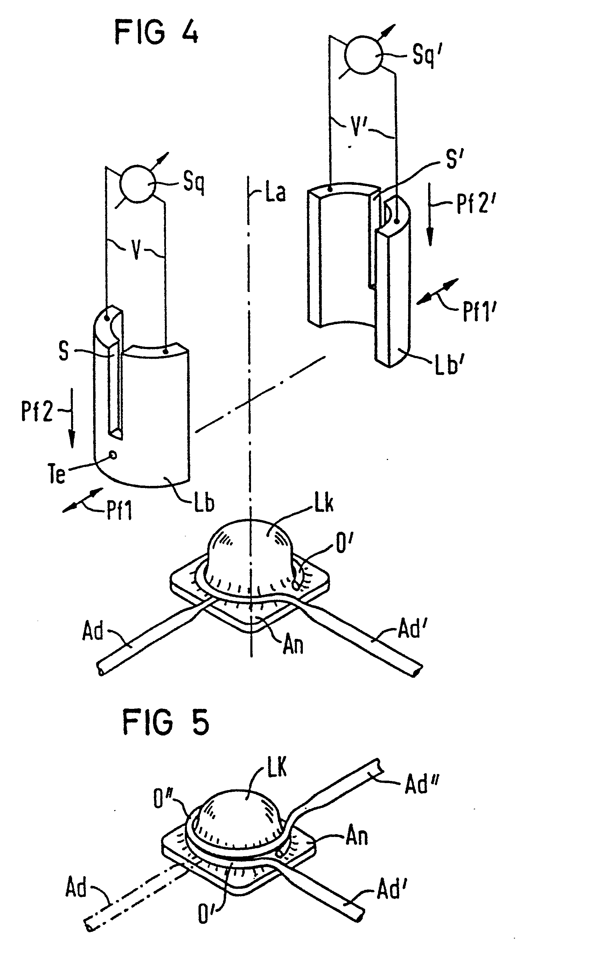

Die beim Anlöten des Änderungsdrahtes Ad gebildete Lotkuppe Lk kann gemäß Figur 3 beim Anlöten eines weiteren Änderungsdrahtes Ad' als Zentrierhilfe und als Lotdepot verwendet werden. Hierzu wird die verzinnte Öse O' des weiteren Änderungsdrahtes Ad' auf der Lotkuppe Lk positioniert. Die Lötbacken Lb und Lb' werden dann in Richtung der Doppelpfeile Pf1 bzw. Pf1' geschlossen und in Richtung der Pfeile Pf2 bzw. Pf2' auf die Lotkuppe Lk abgesenkt und federnd gegen die Anschlußfläche An gedrückt. Daraufhin werden die Lötbacken Lb und Lb' mit einem Stromimpuls zum Aufschmelzen der Lotkuppe Lk beheizt. Dabei dienen die Lötbacken Lb und Lb' bis zum vollständigen Erstarren des Lotes als Niederhalter für den Anschlußdraht Ad und den weiteren Anschlußdraht Ad'. Nach dem Erstarren des Lotes werden dann die Lötbacken Lb und Lb' geöffnet und von der Anschlußfläche An abgehoben. Die in Figur 4 nicht erkennbare Öse des Änderungsdrahtes Ad und die Öse O' des Änderungsdrahtes Ad' sind dann in die durch das Aufschmelzen der Lotkuppe Lk in den Lötbacken Lb und Lb' neu gebildete Lotkuppe eingebettet.

Figur 5 zeigt, daß nach dem Anlöten eines Änderungsdrahtes Ad auch zwei weitere Änderungsdrähte Ad' und Ad'' mit ihren Ösen O' bzw. O'' auf der Lotkuppe Lk positioniert werden können. Das Anlöten der weiteren Änderungsdrähte Ad' und Ad' erfolgt dann in einem Arbeitsgang in der zuvor beschriebenen Weise durch das Aufschmelzen der Lotkuppe Lk. Die Lötbacken Lb und Lb' (vgl. Figur 4) dienen dann bis zum Erstarren der neu gebildeten Lotkuppe als Niederhalter für die Änderungsdrähte Ad, Ad' und Ad''.

Der Änderungsdraht Ad ist in Figur 4 strichpunktiert dargestellt. Hierdurch soll angedeutet werden, daß auf einer Anschlußfläche An auch zunächst nur eine Lotkuppe Lk gebildet werden kann. Auf diese Lotkuppe werden dann die Ösen O' und O'' der Änderungsdrähte Ad' bzw. Ad'' positioniert und in eine durch Aufschmelzen der Lotkuppe Lk neu gebildete Lotkuppe eingebettet. Die Herstellung einer Lotkuppe Lk kann also auch allein erfolgen, d.h. sie braucht nicht mit dem Anlöten eines Änderungsdrahtes Ad verbunden sein.

Die beschriebene Löteinrichtung läßt sich aber auch zum Kontaktieren von Änderungsdrähten an aus einer Leiterplatte überstehende Bauteileanschlüsse einsetzen. Dabei wird jedoch kein zusätzliches Lot in die Lötbacken Lb und Lb' (vgl. Figur 1) eingeführt. Die Lötbacken Lb und Lb' umschließen dabei den Bauteileanschluß und schmelzen das durch den Schwallvorgang abgeschiedene Lot auf. Während des Abkühlvorgangs dienen die Lötbacken Lb und Lb' dann in der beschriebenen Weise als Niederhalter für den Änderungsdraht.

Sollen an einen aus einer Leiterplatte überstehenden Bauteileanschluß mehrere Änderungsdrähte angelötet werden, so reicht die durch den Schwallvorgang abgeschiedene Lotmenge nicht aus. In diesem Fall wird dann ggf. mit dem Anlöten eines ersten Änderungsdrahtes auf dem Bauteileanschluß eine Lotkupppe geformt, welche dann beim Anlöten weiterer Änderungsdrähte als Zentrierhilfe und als Lotdepot dient.

## Patentansprüche

1. Löteinrichtung, insbesondere zum Herstellen von nachträglichen Verbindungsänderungen an Leiterplatten, mit einem durch elektrische Widerstandsheizung auf Arbeitstemperatur erwärmbaren Lötelement (L), welches eine mit der Lötstelle in eine unmittelbare Berührung bringbare Arbeitsfläche (A) und einen zur Lötstelle hin offenen Hohlraum aufweist, gekennzeichnet durch folgende Merkmale:

a) das Lötelement (L) ist durch zwei halbschalenförmige Lötbacken (Lb, Lb') aus Widerstandsmaterial gebildet,

b) die beiden Lötbacken (Lb, Lb') sind auf die Lötstelle absenkbar und zum Öffnen und Schließen relativ zueinander verstellbar,

c) jede Lötbacke (Lb, Lb') ist zumindest in dem an die Arbeitsfläche (A) angrenzenden Bereich durch elektrische Widerstandsheizung auf Arbeitstemperatur erwärmbar.

2. Löteinrichtung nach Anspruch 1, dadurch gekennzeichnet, daß die Lötbacken (Lb, Lb') federnd auf die Lötstelle drückbar sind.

3. Löteinrichtung nach Anspruch 1 oder 2, dadurch gekennzeichnet, daß in jede Lötbacke (Lb, Lb') ein vor der Arbeitsfläche (A) endender Schlitz (S, S') eingebracht ist und daß die durch den Schlitz (S, S') voneinander getrennten Lötbackenteile an eine Stromquelle (Sq, Sq') angeschlossen sind.

4. Löteinrichtung nach einem der vorhergehenden Ansprüche, dadurch gekennzeichnet, daß jeder Lötbacke (Lb, Lb') ein regelbarer Transformator zugeordnet ist.

5. Löteinrichtung nach einem der Ansprüche 1 bis 3, dadurch gekennzeichnet, daß mit Hilfe eines an einer Lötbacke (Lb) angebrachten Thermoelements (Te) eine über die Dauer der Lötzeit konstante Arbeitstemperatur einstellbar ist.

6. Löteinrichtung nach einem der Ansprüche 3 bis 5, dadurch gekennzeichnet, daß jede Lötbacke (Lb, Lb') durch einen Stromimpuls heizbar ist.

7. Löteinrichtung nach Anspruch 6, dadurch gekennzeichnet, daß die Zeitdauer eines Stromimpulses und die Leistung durch einen Takter steuerbar sind.

8. Verfahren zum Anlöten von Änderungsdrähten an Anschlußflächen einer Leiterplatte unter Verwendung einer Löteinrichtung nach einem der Ansprüche 1 bis 7, dadurch gekennzeichnet, daß zunächst eine definierte Menge Lotdraht zwischen die geöffneten Lötbacken (Lb, Lb') eingebracht wird, daß dann die Lötbacken (Lb, Lb') geschlossen und mit einem Stromimpuls derart beheizt werden, daß das in den Hohlraum der Lötbacken (Lb, Lb') eingeklemmte Lot abgeschmolzen wird und sich ein aus der Arbeitsfläche herausragender Lottropfen bildet, daß nach den Erstarren des Lottropfens die Lötbacken (Lb, Lb') auf die mit einer Öse eines Änderungsdrahtes (Ad) belegte Anschlußfläche (An) gedrückt werden, daß die Lötbacken (Lb, Lb') erneut mit einem Stromimpuls zum Aufschmelzen des Lottropfens beheizt werden und daß die Lötbacken (Lb, Lb') bis zum Erstarren des Lotes auf der Anschlußfläche (An) verbleiben.

9. Verfahren nach Anspruch 8, dadurch gekennzeichnet, daß die Lötbacken (Lb, Lb') nach dem Erstarren des Lotes geöffnet und von der Anschlußfläche (An) abgehoben werden.

10. Verfahren nach Anspruch 8 oder 9, dadurch gekennzeichnet, daß die beim Anlöten eines Änderungsdrahtes (Ad) auf der Anschlußfläche (An) gebildete Lotkuppe (Lk) beim Anlöten eines weiteren Änderungsdrahtes (Ad', Ad'') als Zentrierhilfe und als Lotdepot verwendet wird.

11. Verfahren nach Anspruch 10, dadurch gekennzeichnet, daß zum Anlöten eines weiteren Änderungsdrahtes (Ad') zunächst dessen Öse (O') um die Lotkuppe (Lk) gelegt wird, daß dann die geschlossenen Lötbacken (Lb, Lb') abgesenkt und mit einem Stromimpuls zum Aufschmelzen der Lotkuppe (Lk) beheizt werden und daß die Lötbacken (Lb, Lb') bis zum Erstarren des Lotes auf der Anschlußfläche (An) verbleiben.

## Claims

1. A soldering device, particularly but not exclusively for the production of supplementary connection modifications on printed circuit boards, comprising a soldering element (L) which can be heated to working temperature by electrical resistance heating and which has a working surface (A) which can be brought into direct contact with the place to be soldered, and a cavity which is open towards the place to be soldered, characterised by the following features:

a) the soldering element (L) is formed by two half shell-shaped soldering jaws (Lb, Lb')made of resistant material,

b) the two soldering jaws (Lb, Lb') can be lowered onto the place to be soldered and are adjustable relative to one another for opening and closing purposes,

c) at least in the region which adjoins the working surface (A), each soldering jaw (Lb, Lb') can be heated to working temperature by electrical resistance heating.

2. A soldering device as claimed in claim 1, characterised in that the soldering jaws (Lb, Lb') can be resiliently pressed on to the place to be soldered.

3. A soldering device as claimed in claim 1 or claim 2, characterised in that a slot (S, S') which terminates prior to the working surface (A), is inserted in each soldering jaw (Lb, Lb'); and that the parts of the soldering jaw, which are separated from one another by the slot (S,S'), are connected to a current source (Sq, Sq').

4. A soldering device as claimed in one of the preceeding claims, characterised in that each soldering jaw (Lb, Lb') is allotted a regulatable transformer.

5. A soldering device as claimed in one of claims 1 to 3, characterised in that a working temperature which remains constant for the duration of the soldering time, can be set by means of a thermo-element (Te) mounted on a soldering jaw (Lb).

6. A soldering device as claimed in one of claims 3 to 5, characterised in that each soldering jaw (Lb, Lb') can be heated by a current pulse.

7. A soldering device as claimed in claim 6, characterised in that the duration of a current pulse and the power can be controlled by a timer.

8. A process for soldering modifying wires to terminal surfaces of a printed circuit board using a soldering device as claimed in one of claims 1 to 7, characterised in that a predetermined amount of soldering wire is first introduced between the open soldering jaws (Lb, Lb'); that the soldering jaws (Lb, Lb') are then closed and heated by a current pulse in such manner that the solder which is wedged in the cavity of the soldering jaws (Lb, Lb') melts and a drop of solder is formed which projects from the working surface; and that when the drop of solder has solidified, the soldering jaws (Lb, Lb') are pressed onto the terminal surface (An), to which a loop of a modifying wire (Ad) has been applied; that the soldering jaws (Lb, Lb') are again heated by a current pulse unit until the drop of solder melts; and that the soldering jaws (Lb, Lb') remain in contact with the terminal surface (An) until the solder solidifies.

9. A process as claimed in claim 8, characterised in that when the solder has solidified, the soldering jaws (Lb, Lb') are open and raised from the terminal surface (An).

10. A process as claimed in claim 8 or claim 9, characterised in that the solder dome (Lk), which forms on the terminal surface (An) during the soldering of a modifying wire (Ad) is used as a centering aid and as a solder reservoir during the soldering of a further modifying wire (Ad', Ad'').

11. A process as claimed in claim 10, characterised in that in order to solder a further modifying wire (Ad'), the loop (O') thereof is first positioned around the solder dome (Lk); that the closed soldering jaws (Lb, Lb') are then lowered and heated by a current pulse until the solder dome (Lk) melts; and that the soldering jaws (Lb, Lb') remain in contact with the terminal surface (An) until the solder solidifies.

## Revendications

1. Dispositif de soudage, notamment pour l'établissement de modifications ultérieures de connexion sur des plaquettes à circuits imprimés, comportant un organe de soudage (L), qui peut être chauffé à une température de travail par un dispositif de chauffage à résistance électrique et qui possède une surface de travail (A) pouvant être amenée en contact direct avec le point de soudure et une cavité ouverte en direction du point de soudure, caractérisé par les particularités suivantes:

a) un organe de soudage (L) est formé par deux mâchoires de soudage en forme de demi-coques (Lb, Lb') constituées en un matériau formant résistance,

b) les deux mâchoires de soudage (Lb, Lb') peuvent être abaissées sur le point de soudure et être déplacées l'une par rapport à l'autre dans le sens de l'ouverture et de la fermeture,

c) chaque mâchoire de soudage (Lb, Lb') peut être chauffée à une température de travail, au moyen d'un chauffage à résistance électrique, au moins dans la zone jouxtant la surface de travail (A).

2. Dispositif de soudage selon la revendication 1, caractérisé en ce que les mâchoires de soudage (Lb, Lb') peuvent être comprimées élastiquement sur le point de soudure.

3. Dispositif de soudage suivant la revendication 1 ou 2, caractérisé par le fait qu'une fente (S, S') se terminant en-deçà de la surface de travail (A) est ménagée dans chaque mâchoire de soudage (Lb, Lb') et que les parties des mâchoires de soudage, séparées par la fente (S, S') sont raccordées à une source de courant (Sq, Sq').

4. Dispositif de soudage suivant l'une des revendications précédentes, caractérisé par le fait qu'un transformateur réglable est associé à chaque mâchoire de soudage (Lb. Lb').

5. Dispositif de soudage suivant l'une des revendications 1 à 3, caractérisé par le fait qu'une température de travail, constante pendant la durée du soudage, est réglable à l'aide d'un thermocouple (Te) monté sur une mâchoire de soudage (Lb).

6. Dispositif de soudage suivant l'une des revendications 3 à 5, caractérisé par le fait que chaque mâchoire de soudage (Lb, Lb') peut être chauffée au moyen d'une impulsion de courant.

7. Dispositif de soudage suivant la revendication 6, caractérisé par le fait que la durée d'une impulsion de courant et la puissance peuvent être commandées par un générateur de cadence.

8. Procédé pour souder des fils de modification sur des surfaces de raccordement d'une plaquette à circuits imprimés moyennant l'utilisation d'un dispositif de soudage suivant l'une des revendications 1 à 7, caractérisé par le fait qu'on insère au moins une quantité définie de soudure en fil entre les mâchoires de soudage (Lb, Lb') ouvertes, qu'on ferme ensuite les mâchoires de soudage (Lb, Lb') et qu'on chauffe avec une impulsion de courant de telle sorte que la soudure coincée dans la cavité des mâchoires de soudage (Lb, Lb') fond et qu'il se forme une goutte de soudure qui fait saillie par rapport à la surface de travail, qu'après solidification de la goutte de soudure, on comprime les mâchoires de soudage (Lb, Lb') contre la surface de raccordement (An) équipée d'un oeillet d'un fil de modification (Ad), qu'on chauffe à nouveau les mâchoires de soudage (Lb, Lb') avec une impulsion de courant de manière à faire fondre la goutte de soudure et que les mâchoires de soudage (Lb, Lb') restent sur la surface de raccordement (An) jusqu'à la solidification de la soudure.

9. Procédé suivant la revendication 8, caractérisé par le fait qu'on ouvre les mâchoires de soudage (Lb, Lb') après la solidification de la soudure et qu'on les écarte de la surface de raccordement (An).

10. Procédé suivant la revendication 8 ou 9, caractérisé par le fait qu'on utilise le bouton de soudure (Lk) formé lors du soudage d'un fil de modification (Ad) sur la surface de raccordement (An), en tant que dispositif auxiliaire de centrage et dépôt de soudure lors du soudage d'un autre fil de modification (Ad', Ad'').

11. Procédé suivant la revendication 10, caractérisé par le fait que pour réaliser le soudage d'un autre fil de modification (Ad'), on applique tout d'abord l'oeillet (O') de ce fil autour du bouton de soudure (Lk), puis qu'on abaisse les mâchoires de soudage fermées (Lb, Lb') et qu'on chauffe au moyen d'une impulsion de courant pour faire fondre le bouton de soudure (Lk) et que les mâchoires de soudage (Lb, Lb') restent sur la surface de raccordement (An) jusqu'à la solidification de la soudure.

## FIG 1

## FIG 2

## FIG 3

# FIG 4

# FIG 5